# FASCICULE DE BREVET EUROPEEN

(11) **EP 1 622 437 B1**
(45) Date de publication et mention de la délivrance du brevet: **03.05.2017**
(21) Numéro de dépôt: 05106650.4
(22) Date de dépôt: 20.07.2005
(51) Int. Cl.: H05K 3/46

(54) **Procédé d'encollage ou d'assemblage de plusieurs éléments**
Glueing or assembling method for a plurality of elements
Verfahren zum Verkleben oder Zusammenstellen mehrerer Elemente

(30) Priorité: 23.07.2004 FR 0408190
(43) Date de publication de la demande: 01.02.2006
(73) Titulaire: Thales, 92400 Courbevoie (FR)
(72) Inventeur: Ngo Bui Hung, Frédéric, 94117 CX Arcueil (FR)
(74) Mandataire: Dudouit, Isabelle

(56) Documents cités:
- FR-A- 2 659 344
- PATENT ABSTRACTS OF JAPAN vol. 002, no. 048 (C-010), 31 mars 1978 (1978-03-31) -& JP 53 006341 A (NITTO ELECTRIC IND CO LTD), 20 janvier 1978 (1978-01-20)
- PATENT ABSTRACTS OF JAPAN vol. 2003, no. 12, 5 décembre 2003 (2003-12-05) -& JP 2004 179397 A (FUJI ELECTRIC HOLDINGS CO LTD), 24 juin 2004 (2004-06-24)
- PATENT ABSTRACTS OF JAPAN vol. 017, no. 507 (M-1479), 13 septembre 1993 (1993-09-13) -& JP 05 131545 A (DAINIPPON PRINTING CO LTD), 28 mai 1993 (1993-05-28)

## Description

L'invention concerne un procédé d'assemblage ou d'encollage d'un ou de plusieurs éléments susceptibles de contenir des bulles d'air.

Elle s'applique par exemple pour la fabrication d'antennes imprimées composées de plusieurs couches.

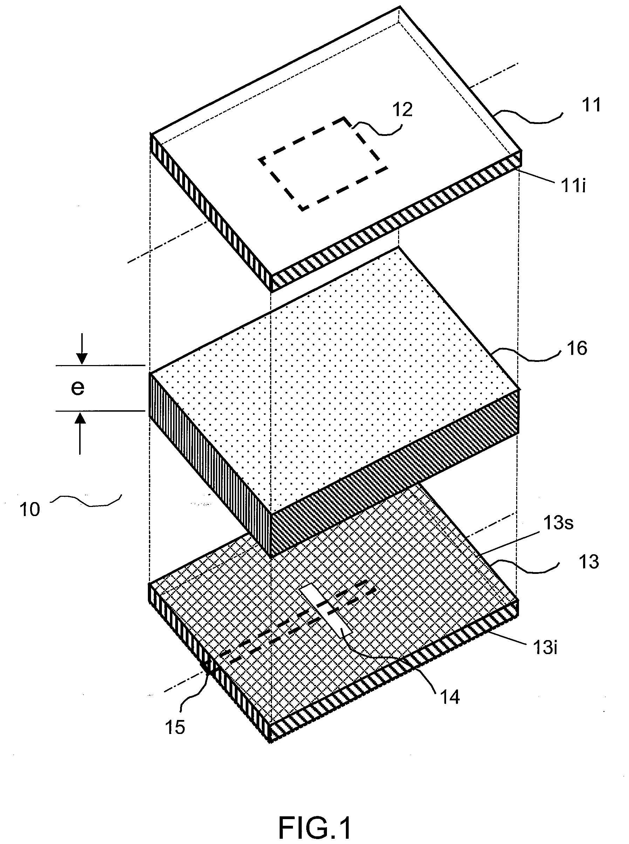

Les antennes imprimées, dénommées plus usuellement par l'appellation anglo-saxonne antenne-patch, sont bien connues. Une des variantes couramment mise en oeuvre est rappelée à la figure 1 où un seul élément rayonnant est représenté pour faciliter la compréhension de la description. En pratique, les antennes de type imprimé comportent en général plusieurs éléments rayonnants pour former un réseau et présenter de ce fait des dimensions importantes.

La figure 1 schématise un exemple d'antenne imprimée 10 constituée principalement d'un circuit imprimé simple face 11 sur lequel est gravé, sur la face inférieure 11a métallisée, un élément rayonnant 12. La matière du substrat du circuit imprimé 11, la forme et la taille de l'élément rayonnant 12, sont choisies et déterminées suivant l'application qu'on en fait. Ce circuit imprimé 11 est usuellement placé à une distance (e) d'un deuxième circuit imprimé 13 dit d'alimentation qui est, dans cet exemple, réalisé à partir d'un circuit imprimé double face; sur sa face supérieure 13s, une fente 14 y est réalisée pour exciter l'élément rayonnant 12 et sur sa face inférieure 13i est gravée une ligne de transmission 15 pour amener l'énergie RF (radio-fréquences) et/ou éventuellement pour assurer l'adaptation de l'antenne. Afin de garantir l'écartement (e) entre les deux circuits imprimés 11, 13 composant l'antenne, en particulier dans le cas d'antenne constituée de plusieurs éléments rayonnants, donc de grande dimension, il est courant d'intercaler une plaque de mousse rigide 16, par exemple de la mousse à base de polyméthacrylimide expansée, entre ces deux circuits.

Il est connu que le positionnement relatif des deux circuits imprimés 11 et 13 a une grande influence sur les caractéristiques fonctionnelles de l'antenne.

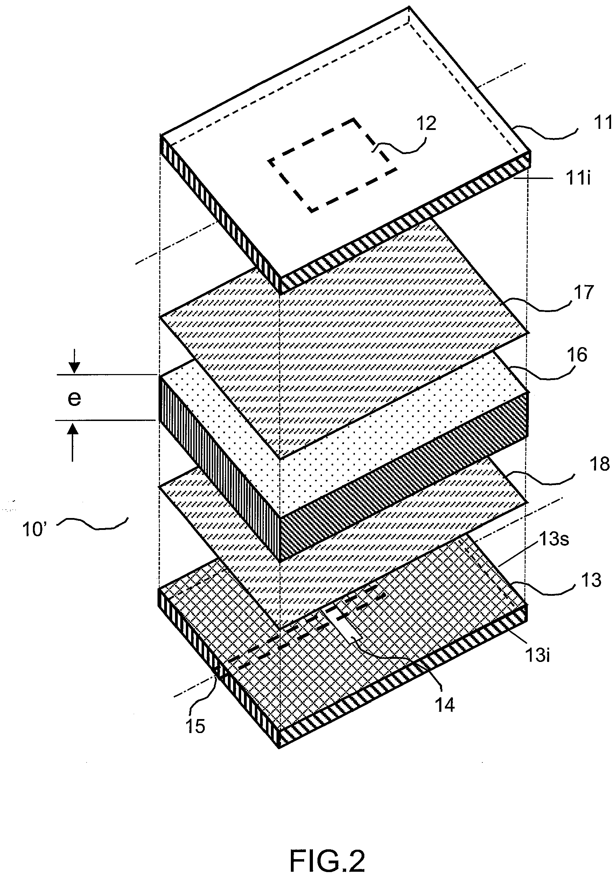

Afin de maintenir ce positionnement relatif, il est courant de coller les trois composants 11, 16, 13 de l'antenne présentée ci dessus, par deux films de colle auto-collant 17 et 18. La figure 2 représente la composition d'une antenne 10' mettant en oeuvre des films de colle. Ces films de colle peuvent être des films d'adhésif de type acrylique du commerce, par exemple ceux de la Société 3M.

Ce procédé d'assemblage présente toutefois plusieurs inconvénients, pour les antennes qui ont une taille importante ou qui sont susceptibles de subir des contraintes thermiques sévères ou de devoir résister à des charges mécaniques élevées, combinées ou non à des contraintes thermiques.

Dans le cas des antennes de grande taille, l'application des films de colle auto-collant n'est pas aisée ; des bulles d'air risquent d'être emmagasinées entre les couches et d'engendrer le rebut de l'antenne en sortie de chaîne de fabrication.

Sous contraintes thermiques sévères, par exemple en utilisation en plein désert, un décollement est souvent observé lors de l'exploitation de l'antenne.

Dans certaines conditions d'utilisation, par exemple pour les antennes exposées à des rafales de vents, les contraintes mécaniques induites, en particulier celles provenant des efforts de flexion, dépassent la résistance aux cisaillements du film de colle et entraînent la dégradation de l'antenne.

Afin de supprimer les bulles d'air et d'augmenter la tenue de l'antenne aux agressions d'exploitation abordées ci dessus, il est connu de remplacer les films de colle auto-collant usuels par des films de colle thermodurcissable.

Cependant, cette solution demande des dispositions dont la mise en oeuvre n'est pas toujours possible. En effet, les films de colle thermodurcissable nécessitent de chauffer l'ensemble des composants de l'antenne 10' de la figure 2, à des températures nettement supérieures à une centaine de degrés Celsius pour permettre leur polymérisation. Ces températures sont parfois incompatibles avec la température maximale admissible par la couche de mousse 16.

De plus, pour chasser les bulles d'air et assurer l'adhérence optimale entre les couches, une pression doit être appliquée à l'ensemble 10' pendant toute la durée du processus de polymérisation, ce qui nécessite l'utilisation d'une presse de très grande capacité. Ceci conduit à un processus très coûteux si l'antenne est de grande taille.

Une autre solution connue de l'art antérieur est d'utiliser de la colle sous forme de liquide thermo-durcissable et de réaliser l'assemblage par la technique dite de sac à vide, qui consiste à mettre l'ensemble à coller dans un sac scellé hermétiquement et à faire le vide durant le temps nécessaire à la polymérisation.

Cette solution quoique efficace pour des équipements de petites dimensions, laisse parfois de grosses bulles d'air pour des équipements de grandes dimensions car le vide et la pression (provenant de la pression atmosphérique) sont appliqués simultanément. Pour pallier ce défaut, il est parfois nécessaire d'utiliser un autoclave coûteux et dont l'exploitation reste délicate.

Le brevet FR-A-2 659 344 divulgue un procédé s'appliquant à des éléments rigides et non poreux et à un moyen de collage instantané.

Le résumé obtenu issu de la base Patent Abstracts of Japan vol.002, n°.048 (C-010), 31 mars 1978 (1978-03-31) et JP 53 006341 A (Nitto Electric IND CO LTD), 20 janvier 1978 (1978-01-20) divulgue un procédé d'encollage utilisant une enceinte en deux parties séparées par une membrane, sans communication entre les parties et un procédé consistant à d'abord faire le vide dans l'enceinte contenant les éléments à coller puis à casser le vide dans la partie supérieure pour que la membrane exerce une pression sur ces éléments.

L'invention concerne une nouvelle approche d'assemblage de plusieurs éléments entre eux, pouvant par exemple constituer une antenne.

L'invention concerne un dispositif d'assemblage et/ou d'encollage d'au moins deux éléments contenant des bulles d'air caractérisé en ce qu'il comporte au moins les éléments suivants :
∘ une enceinte comprenant au moins une première partie (I) recevant les éléments à assembler et une deuxième partie (II),
∘ un moyen de séparation des deux parties permettant d'exercer une pression sur les éléments à assembler,
∘ un dispositif d'introduction et/ou d'évacuation d'un effluent sous pression au niveau de chacune des parties, adapté à introduire au niveau de la première partie (I) et de la deuxième partie (II) une pression sensiblement identique et égale à une pression choisie pour évacuer l'air emprisonné dans les éléments à assembler et une fois l'air évacué, ledit dispositif est adapté à appliquer une pression sur l'ensemble des éléments à assembler tout en conservant une pression inférieure dans la partie de l'enceinte contenant les éléments à assembler.
∘ un conduit de circulation d'effluent muni d'un robinet permettant la communication des deux enceintes.

Elle concerne aussi un procédé d'assemblage d'au moins deux éléments caractérisé en ce qu'il comporte au moins les étapes suivantes :
a) positionner les éléments à assembler dans une partie (I) d'une enceinte,
b) introduire dans les deux parties (I) et (II) formant l'enceinte une pression sensiblement identique et égale à une pression suffisante pour évacuer l'air emprisonné dans les éléments,
c) une fois l'air évacué, appliquer une pression sur l'ensemble des éléments à assembler tout en conservant une pression inférieure dans la partie de l'enceinte contenant les éléments à encoller.

Le procédé de fabrication selon l'invention permet notamment d'assembler des éléments formant des antennes de grande dimension sans devoir disposer d'équipements plus coûteux que des équipements de chauffe, de presse de grande capacité ou d'autoclave.

L'opération de vide et l'opération de mise sous pression des éléments sont séparées permettant ainsi de mieux éliminer toutes les bulles d'air éventuellement présentes entre les couches à assembler et entre les couches et les éléments du dispositif avec lesquelles elles sont en contact.

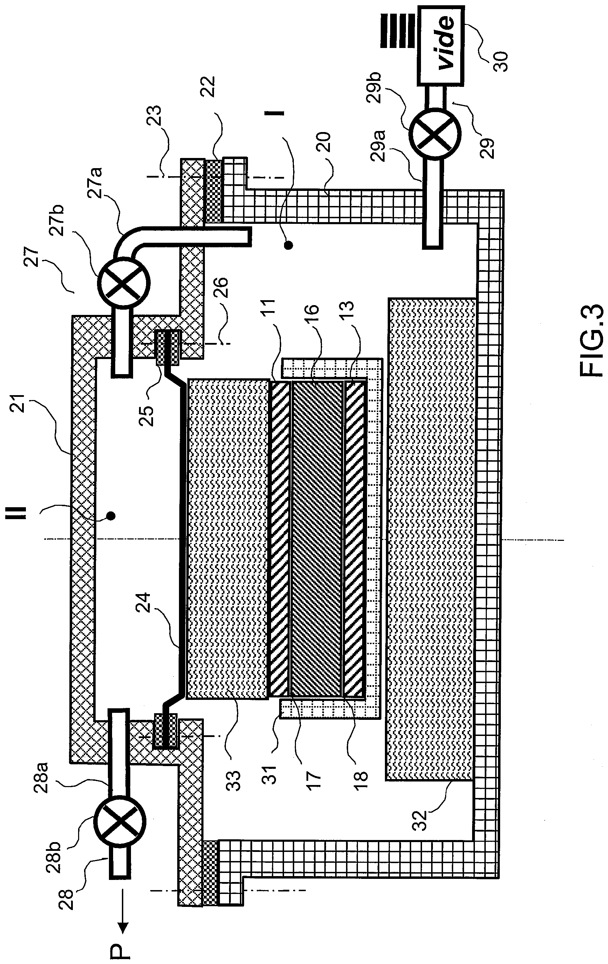

D'autres caractéristiques et avantages du procédé selon l'invention apparaîtront mieux à la lecture de la description qui suit donnée à titre illustratif et nullement limitatif d'un exemple de réalisation annexé des figures qui représentent :
∘ Les figures 1 et 2 des exemples d'antenne selon l'art antérieur,
∘ La figure 3 un exemple de dispositif d'assemblage selon l'invention.

Afin de mieux faire comprendre le procédé selon l'invention, l'exemple donné ci-après concerne un procédé d'assemblage et de collage de plusieurs couches superposées formant une antenne imprimée (ou antenne patch). Il s'applique plus généralement pour le collage d'un ensemble d'éléments superposés nécessitant l'emploi du vide et d'une pression au cours du procédé.

En résumé, le procédé utilise deux enceintes (I) et (II) solidaires, ayant des parois peu déformables, adjacentes, séparées l'une de l'autre par une paroi mobile ou tout autre élément équivalent ayant notamment pour objet d'exercer une pression sur l'ensemble des couches à assembler. Quand ce système est ouvert, les deux enceintes se comportent comme une enceinte unique dans laquelle on peut faire le vide et éliminer l'air emmagasiné dans tout équipement placé à l'intérieur de l'enceinte (I). Puis, quand le système est fermé, les deux enceintes sont séparées et toute différence de pression entre les deux enceintes engendre un effort de compression qui peut être appliqué à tout équipement ou élément placé dans l'enceinte (I) par le biais de la paroi mobile.

La figure 3 représente un exemple de dispositif d'assemblage permettant de mettre en oeuvre le procédé selon l'invention.

Le dispositif comporte par exemple une enceinte comprenant deux parties (I) et (II) considérées dans la description comme deux enceintes pour des raisons de simplicité.

L'enceinte (I) est délimitée par une cuve 20 dont la taille est choisie en fonction des éléments 11, 16, 13 constituant l'antenne à assembler, et dont l'épaisseur des parois est dimensionnée en fonction de la matière utilisée (acier, alliage léger ou autre) et pour résister au moins à la pression de travail P soit pour l'exemple, à la pression atmosphérique. La pression de travail correspond à la pression utilisée au cours du procédé de fabrication pour parvenir à l'assemblage des éléments).

L'enceinte (II) est constituée par un couvercle 21 s'adaptant sur la cuve 20 et fermant hermétiquement cette dernière par un joint d'étanchéité 22 et des dispositifs de fixation et de serrage 23, par exemple des vis, des boulons, des brides ou autres, non représentés pour faciliter la compréhension. Le couvercle 21 est dimensionné pour résister à la pression atmosphérique, dans cet exemple d'application.

A la partie inférieure du couvercle 21, se trouve une membrane déformable 24 fixée par un joint de scellement 25 et un moyen de fixation 26 non représenté. La membrane délimite l'enceinte (II) et joue le rôle de paroi mobile précitée commune aux deux enceintes et exerçant une pression sur les éléments. La membrane 24 n'est pas tendue mais par exemple scellée avec du mou pour permettre un certain débattement et donc un certain enfoncement dans l'enceinte (I) sans s'arracher.

La membrane 24 est réalisée par exemple à partir d'une feuille souple de polyamide (par exemple du CAPRAN 518 commercialisé par la Société AEROVAC) et l'ensemble formé par le joint de scellement 25 et le moyen de fixation 26 peut être réalisé à partir de ruban malléable auto-adhérant tel que du SM5126-2 commercialisé par la Société AEROVAC; ces matériaux sont connus de l'homme du métier.

Les enceintes (I) et (II) sont par exemple mises en communication l'une avec l'autre par le biais d'un dispositif 27 composé d'un tuyau 27a équipé d'un robinet 27b.

L'enceinte (II) peut être mise à l'air libre ou branchée à une source d'air sous pression, par le biais d'un dispositif 28 composé d'un tuyau 28a équipé d'un robinet 28b alors que l'enceinte (I) est par exemple reliée à une pompe à vide 30 par un dispositif 29 composé d'un tuyau 29a équipé d'un robinet 29b.

Pour s'assurer du bon positionnement des composants 11, 16, 13 de l'antenne, un gabarit de montage 31 réalisé suivant une technique connue de l'Homme du métier, non décrite ici, est utilisé.

Avant d'effectuer l'assemblage des composants 11, 16 et 13, les circuits imprimés 11 et 13 sont préencollés sur leur face qui sera mise en contact avec la couche de mousse 16 afin de réaliser respectivement les deux films de colle 17 et 18. L'encollage peut se faire par les techniques usuelles connues telles que l'encollage à la spatule, au rouleau, à l'applicateur - doseur. La colle utilisée est de préférence liquide et du type thermodurcissable à polymérisation à température ambiante ; par exemple, de la colle bi-composant à base de résine epoxide AW106 commercialisé par la Société VANTICO.

Après encollage, les composants 11, 16, 13 sont assemblés dans le gabarit de montage 31 et l'ensemble est placé dans l'enceinte (I) entre un jeu de deux cales 32 et 33, qui permet essentiellement de rattraper la hauteur des différents modèles d'antennes fabriqués avec la même enceinte.

L'épaisseur des cales est réglée pour que la face supérieure de la cale 33 soit au niveau de la membrane 24. Le choix de la section de la cale 33 permet également de faire la transition entre la surface de la membrane 24 et la section propre de l'antenne à assembler. Initialement tous les robinets 27b, 28b et 29b sont fermés.

La membrane souple peut être remplacée par un piston jouant un rôle similaire et fixé à l'enceinte de façon à assurer l'étanchéité.

Le procédé selon l'invention comporte par exemple les étapes suivantes :
a) introduire les éléments à assembler dans l'enceinte (I),
b) ouvrir le robinet 27b pour mettre les deux enceintes (I) et (II) sensiblement à la même pression, puis ouvrir le robinet 29b pour faire le vide dans les deux enceintes, ou mettre les deux enceintes à une pression sensiblement voisine du vide,
   Durant cette opération de mise sous vide, comme aucune pression n'est appliquée sur les éléments 11, 16, 13, les bulles d'air emmagasinées lors de l'encollage peuvent s'évacuer rapidement et sans contrainte. Les films de colle 17 et 18 à l'issue de cette opération sont exempts de bulles d'air. De manière plus générale la valeur de la pression est fixée afin d'assurer l'élimination des bulles sans appliquer de pression sur les éléments.
c) refermer le robinet 27b pour isoler les deux enceintes,
d) ouvrir le robinet 28b, afin de porter l'enceinte (II) ne comportant pas les éléments à assembler par exemple à la pression atmosphérique. La membrane 24 appuie par l'intermédiaire de la cale 33 sur l'ensemble des éléments (11, 16, 13) à assembler. La pression appliquée sur ces éléments est égale à la différence de pression entre les deux enceintes (II) et (I). Le niveau de pression de l'enceinte (I) contenant les éléments à assembler est maintenu à une valeur inférieure à celui de l'autre enceinte (II).
   En réglant le niveau de vide développé dans l'enceinte (I) avant l'ouverture du robinet 28b il est possible d'ajuster la valeur de la pression appliquée aux éléments pour tenir compte de la capacité de tenue mécanique en compression de la couche de mousse employée.
e) après polymérisation de la colle, refermer le robinet 29b et ouvrir le robinet 27b pour mettre à l'air libre l'ensemble des éléments assemblés et permettre le démontage du couvercle 21 de la cuve 20 et la sortie de l'antenne assemblée.

## Revendications

1. Dispositif d'assemblage et/ou d'encollage d'au moins deux éléments contenant des bulles d'air, comportant au moins les éléments suivants :
∘ une enceinte comprenant au moins une première partie (I) recevant les éléments à assembler et une deuxième partie (II),
∘ la première partie (I) comporte un conduit (29a) équipé d'un robinet (29b) et d'une pompe à vide (30),
∘ un moyen (24) de séparation des deux parties permettant d'exercer une pression sur les éléments à assembler,
∘ un dispositif d'introduction et/ou d'évacuation d'un effluent sous pression au niveau de chacune des parties, adapté à introduire au niveau de la première partie (I) et de la deuxième partie (II) une pression sensiblement identique et égale à une pression suffisante pour évacuer l'air emprisonné dans les éléments à assembler, et une fois l'air évacué, le dispositif est adapté à appliquer une pression sur l'ensemble des éléments à assembler tout en conservant une pression inférieure dans la partie de l'enceinte contenant les éléments à assembler,
∘ **caractérisé en ce qu'**il comporte également un conduit de circulation (27a) d'effluent muni d'un robinet (27b) permettant la communication entre les deux parties (I) et (II) de l'enceinte.

2. Dispositif selon la revendication 1 **caractérisé en ce que** le moyen permettant le maintien sous pression est une membrane (24).

3. Dispositif selon la revendication 1 **caractérisé en ce que** la partie (II) de l'enceinte est en communication avec une source d'air sous-pression, par exemple l'air libre, à travers un dispositif composé d'un conduit (28a) et d'un robinet (28b).

4. Procédé d'assemblage d'au moins deux éléments utilisant le dispositif selon les revendications 1 à 3 et comportant au moins les étapes suivantes :
a) positionner les éléments à assembler dans une partie (I) d'une enceinte,
b) ouvrir le robinet (27b) permettant la communication entre les deux parties (I) et (II) de l'enceinte et, en utilisant le conduit (29a) équipé d'un robinet (29b) et d'une pompe à vide (30) disposé au niveau de la première partie (I), introduire dans les deux parties (I) et (II) formant l'enceinte une pression sensiblement identique et égale à une pression suffisante pour évacuer l'air emprisonné dans les éléments
c) une fois l'air évacué, fermer le robinet (27b) permettant la communication entre les deux parties (I) et (II) de l'enceinte et appliquer une pression sur l'ensemble des éléments à assembler en ouvrant le dispositif d'introduction d'un effluent sous pression disposé au niveau de la deuxième partie (II) tout en conservant une pression inférieure dans la partie de l'enceinte contenant les éléments à assembler.

5. Procédé selon la revendication 4 **caractérisé en ce que** l'on met les deux parties (I) et (II) de l'enceinte à une pression sensiblement égale au vide.

6. Procédé selon la revendication 4 **caractérisé en ce que** l'on utilise une membrane pour exercer la pression sur les éléments à assembler.

7. Procédé selon la revendication 6 **caractérisé en ce que** la dépression est générée par une pompe à vide.

8. Procédé d'assemblage selon la revendication 4, **caractérisé en ce que** la pression P exercée sur les éléments à assembler est sensiblement égale à la pression atmosphérique.

## Patentansprüche

1. Vorrichtung zum Zusammenfügen und/oder Kleben von wenigstens zwei Luftblasen enthaltenden Elementen, die wenigstens die folgenden Elemente umfasst:
∘ eine Kammer, die wenigstens einen die zusammenzufügenden Elemente aufnehmenden ersten Teil (I) und einen zweiten Teil (II) umfasst,
∘ wobei der erste Teil (I) eine Leitung (29a) umfasst, die mit einem Hahn (29b) und einer Vakuumpumpe (30) ausgestattet ist,
∘ ein Mittel (24) zum Trennen der beiden Teile, so dass ein Druck auf die zusammenzufügenden Elemente aufgebracht werden kann,
∘ eine Vorrichtung zum Einleiten und/oder Evakuieren eines Ausflusses unter Druck an jedem der Teile, ausgelegt zum Einleiten, an dem ersten Teil (I) und dem zweiten Teil (II), eines Drucks im Wesentlichen identisch mit und gleich einem Druck, der ausreicht, um die in den zusammenzufügenden Elementen eingeschlossene Luft zu evakuieren, wobei die Vorrichtung so ausgelegt ist, dass sie nach dem Evakuieren der Luft einen Druck auf alle zusammenzufügenden Elemente aufbringt, wobei ein geringerer Druck in dem Teil des Kastens aufrechterhalten wird, der die zusammenzufügenden Elemente enthält,
∘ **dadurch gekennzeichnet, dass** sie auch eine Zirkulationsleitung (27a) für Ausfluss umfasst, ausgestattet mit einem Hahn (27b), der eine Verbindung zwischen den beiden Teilen (I) und (II) der Kammer zulässt.

2. Vorrichtung nach Anspruch 1, **dadurch gekennzeichnet, dass** das Mittel, das das Unterdruckhalten ermöglicht, eine Membran (24) ist.

3. Vorrichtung nach Anspruch 1, **dadurch gekennzeichnet, dass** der Teil (II) der Kammer mit einer Druckluftquelle, beispielsweise mit Freiluft, durch eine Vorrichtung in Verbindung ist, die aus einer Leitung (28a) und einem Hahn (28b) zusammengesetzt ist.

4. Verfahren zum Zusammenfügen von wenigstens zwei Elementen unter Verwendung der Vorrichtung nach den Ansprüchen 1 bis 3, das wenigstens die folgenden Schritte beinhaltet:
a) Positionieren der zusammenzufügenden Elemente in einem Teil (I) einer Kammer,
b) Öffnen des Hahns (27b), der die Verbindung zwischen den beiden Teilen (I) und (II) der Kammer zulässt, und Einleiten unter Verwendung der Leitung (29a), die mit einem Hahn (29b) und einer Vakuumpumpe (30) ausgestattet ist, angeordnet am ersten Teil (I), in die beiden Teile (I) und (II), die die Kammer bilden, eines Drucks, der im Wesentlichen identisch mit und gleich einem Druck ist, der zum Evakuieren der in den Elementen eingeschlossenen Luft ausreicht,
c) Schließen des Hahns (27b), der die Verbindung zwischen den beiden Teilen (I) und (II) der Kammer zulässt, nach dem Evakuieren der Luft, und Aufbringen eines Drucks auf alle zusammenzufügenden Elemente durch Öffnen der am zweiten Teil (II) angeordneten Vorrichtung zum Einleiten eines Ausflusses unter Druck, wobei ein geringerer Druck in dem Teil der Kammer aufrechterhalten wird, der die zusammenzufügenden Elemente enthält.

5. Verfahren nach Anspruch 4, **dadurch gekennzeichnet, dass** die beiden Teile (I) und (II) der Kammer auf einen Druck im Wesentlichen gleich dem Vakuum gesetzt werden.

6. Verfahren nach Anspruch 4, **dadurch gekennzeichnet, dass** eine Membran zum Ausüben des Drucks auf die zusammenzufügenden Elemente benutzt wird.

7. Verfahren nach Anspruch 6, **dadurch gekennzeichnet, dass** der Unterdruck mit einer Vakuumpumpe erzeugt wird.

8. Verfahren zum Zusammenfügen nach Anspruch 4, **dadurch gekennzeichnet, dass** der Druck P, der auf die zusammenzufügenden Elemente ausgeübt wird, im Wesentlichen gleich atmosphärischem Druck ist.

## Claims

1. A device for assembling and/or sticking together at least two elements that contain air bubbles, comprising at least the following elements:
∘ a chamber including at least a first part (I) that receives the elements to be assembled and a second part (II),
∘ the first part (I) comprises a pipe (29a) equipped with a tap (29b) and a vacuum pump (30),
∘ a means (24) for separating the two parts, making it possible to apply pressure to the elements to be assembled,
∘ a device for introducing and/or evacuating a pressurised effluent on each of the parts, adapted to introduce on the first part (I) and on the second part (II) a pressure that is substantially identical and equal to a pressure sufficient to evacuate the air trapped within the elements to be assembled, and once the air has been evacuated, the device is adapted to apply a pressure to all of the elements to be assembled, while maintaining a lower pressure in the part of the chamber that contains the elements to be assembled,
∘ **characterised in that** it also comprises a pipe (27a) for circulating effluent provided with a tap (27b) that enables communication between the two parts (I) and (II) of the chamber.

2. The device according to Claim 1, **characterised in that** the means enabling pressure to be maintained is a membrane (24).

3. The device according to Claim 1, **characterised in that** the part (II) of the chamber is in communication with a pressurised air source, for example the open air, via a device composed of a pipe (28a) and a tap (28b).

4. A method of assembling at least two elements using the device according to Claims 1 and 3 and comprising at least the following steps:
a) positioning the elements to be assembled in one part (I) of a chamber,
b) opening the tap (27b) enabling communication between the two parts (I) and (II) of the chamber and, using the pipe (29a) equipped with a tap (29b) and a vacuum pump (30) disposed on the first part (I), introducing into the two parts (I) and (II) forming the chamber a pressure that is substantially identical and equal to a pressure that is sufficient to evacuate the air trapped within the elements,
c) once the air has been evacuated, closing the tap (27b) enabling communication between the two parts (I) and (II) of the chamber and applying a pressure to all of the elements to be assembled by opening the device for introducing a pressurised effluent disposed on the second part (II) while maintaining a lower pressure in the part of the chamber that contains the elements to be assembled.

5. The method according to Claim 4, **characterised in that** the two parts (I) and (II) of the chamber are set to a pressure substantially equal to a vacuum.

6. The method according to Claim 4, **characterised in that** a membrane is used to apply pressure to the elements to be assembled.

7. The method according to Claim 6, **characterised in that** the depression is generated by a vacuum pump.

8. The method of assembling according to Claim 4, **characterised in that** the pressure P applied to the elements to be assembled is substantially equal to atmospheric pressure.
